# FASCICULE DE BREVET EUROPEEN

(11) **EP 2 925 104 B1**
(45) Date de publication et mention de la délivrance du brevet: **31.07.2019**
(21) Numéro de dépôt: 14305459.1
(22) Date de dépôt: 28.03.2014
(51) Int. Cl.: H05K 7/14, H01H 9/02, H01H 9/16, H01H 9/18

(54) **Dispositif d'interface optimisée pour la commande des équipements d'une installation électrique**
Optimierte Schnittstellenvorrichtung für die Steuerung von Geräten einer elektrischen Anlage
Optimised interface device for controlling systems of an electrical installation

(43) Date de publication de la demande: 30.09.2015
(73) Titulaire: HAGER CONTROLS (Société par Actions Simplifiée), 67700 Saverne (FR)
(72) Inventeur: Paillard, Jean-Noël, 67190 Dinsheim sur Bruche (FR); Lugbull, Pierre-Alain Xavier, 67700 Otterswiller (FR); Colinmaire, Thierry, 57370 Saint Jean Kourtzerode (FR)
(74) Mandataire: Nuss, Laurent

(56) Documents cités:
- DE-A1-102007 058 170
- DE-U1- 20 321 235
- US-B1- 8 269 376
- US-B2- 6 849 968

## Description

La présente invention concerne le domaine des équipements pour installation électrique, notamment le domaine des interfaces permettant la commande desdits équipements, plus particulièrement dans le domaine de la domotique, et a pour objet un dispositif d'interface optimisée pour la commande des équipements d'une telle installation.

On connaît déjà des interfaces hommes machines, communément appelées IHM, qui se présentent sous la forme d'un boîtier renfermant une carte électronique reliée à plusieurs sorties de voies, dites voies, permettant chacune la commande, en tout ou rien ou de façon graduelle, d'un équipement et comprenant un ou plusieurs boutons poussoirs associés chacun à une seule voie. Le boîtier présente une face frontale d'interface et de commande faisant apparaître le ou les boutons poussoirs de sorte à permettre leur sollicitation en vue de l'activation manuelle de la ou de chaque voie associée au ou à l'un des boutons poussoirs. En outre chaque, chaque voie est généralement associée à une LED, ou autre témoin lumineux, relié(e) à la carte électronique et disposée au niveau du ou de l'un des boutons poussoirs pour indiquer l'état d'activation de la voie associée, une LED allumée pouvant alors indiquer à l'opérateur que la voie associée est active, c'est-à-dire dans état d'activation commandant un équipement.

Des interfaces hommes machines comprenant plusieurs boutons poussoirs chacun associés à plusieurs voies sont par exemple connues des documents DE 203 21 235 U1 et US 8,269,376 B1.

D'autre part, chaque voie est généralement prévue pour se trouver dans l'axe du bouton poussoir du côté de la face supérieure ou inférieure du boîtier de l'IHM. Ainsi lorsque par exemple, l'IHM comporte deux rangées superposées de boutons poussoirs, généralement quatre ou cinq boutons poussoirs par rangée, l'IHM comporte alors huit à dix voies pouvant être commandées par les deux rangées de boutons poussoirs et les voies sont alors réparties en quatre ou cinq voies sur la face supérieure et en quatre ou cinq voies sur la face inférieure, chacune dans l'axe de l'un des boutons poussoirs, la rangée supérieure commandant les voies de la face supérieure et la rangée inférieure commandant les voies de la face inférieure.

En outre l'installation électrique, notamment dans le domaine de la domotique, peut inclure en outre un réseau de communication filaire, tel que par exemple un réseau comprenant un bus de communication KNX, ou hertzien. Chaque IHM est relié fonctionnellement, par sa carte électronique, au réseau qui permet d'activer automatiquement à distance, généralement sous la commande d'un système de pilotage domotique, chaque voie de l'IHM. A cet, effet l'IHM comprend en outre un sélecteur manuel mobile entre deux positions, généralement un interrupteur du type glissière à deux positions, permettant de visualiser et de choisir entre deux modes de fonctionnement, à savoir :
- un mode automatique dans lequel, seul les ordres d'activation provenant du réseau sont pris en compte, tandis qu'aucune action manuelle exercée sur les boutons poussoirs n'est prise en compte, l'IHM ne donnant, via l'état des LEDs, que l'état de la voie qui est commandée par le réseau, et
- un mode manuel, dans lequel seules les actions manuelles exercées sur les boutons poussoirs sont prises en compte pour commuter la voie sélectionnée, tandis que les ordres provenant du réseau ne le sont pas, l'IHM ne donnant, via l'état des LEDs, que l'état de la voie qui est commandée par les boutons poussoirs.

Un tel sélecteur comporte un contacteur mobile et un organe de préhension permettant le déplacement manuel du contacteur mobile. L'organe de préhension traverse par une fente prévue à cet effet la face frontale d'interface de l'IHM pour permettre sa manipulation par l'opérateur. En outre la carte électronique comprend deux pistes conductrices fonctionnelles, c'est-à-dire avec un potentiel normalement différent de zéro, et une piste conductrice de référence dont le potentiel est généralement égale à zéro (masse ou terre), mais parfois différent de zéro. Chaque contacteur comporte deux éléments de contact dont l'un, dit élément de contact fonctionnel, est prévu pour être en contact avec l'une ou l'autre des deux pistes conductrices fonctionnelles selon la position du sélecteur pour sélectionner le mode manuel ou le mode automatique et l'autre, dit élément de contact de référence, est prévu pour être en contact permanent, quelque soit la position du sélecteur, avec la piste conductrice de référence qui s'étend sur une surface adaptée à cet effet.

Chaque position du sélecteur correspondant ainsi à une fermeture du circuit (électrique) établi par le contact entre l'élément de contact fonctionnel et l'une des pistes conductrices fonctionnelles et par le contact entre l'élément de contact de référence et la piste de contact de référence.

On notera que toutes les IHM ne comportent pas autant de fonctionnalités de commande ou de visualisation des états des différentes voies. Certaines IHM, plus basiques, ne comportent pas de LEDs et/ou de mode manuel (pas de boutons poussoirs) permettant de commander séparément et manuellement les voies mais uniquement un mode de commutation tout ou rien de toutes les voies ensemble ou aucune voie.

D'autre part, chaque IHM est dimensionnée en largeur selon une norme définissant un nombre de modules. La largeur de l'interface est considérée dans la présente demande et dans la pratique courante comme étant la dimension de l'interface dans le sens perpendiculaire à son épaisseur délimitée entre sa face avant et sa face arrière. Chaque module correspond à une largeur déterminée par la norme. Un module peut alors comprendre une ou plusieurs voies de l'IHM. Les dimensions de l'IHM en largeur dépendent essentiellement du nombre de voies et du nombre de boutons poussoirs qui s'étendent sur la largeur de la face frontale d'interface, c'est-à-dire de gauche à droite pour un observateur située en face de ladite face et regardant cette dernière. Le sélecteur est généralement placé à gauche des boutons poussoirs.

Par ailleurs, chaque bouton poussoir comprend un corps qui est monté sur la carte électronique pour établir le contact électrique avec cette dernière et une tête traversant la face frontale d'interface de l'IHM permettant à l'opérateur de repérer et d'actionner le bouton poussoir. On comprendra alors que la dimension de la carte électronique de l'IHM dépend du nombre de boutons poussoirs implantés sur cette dernière qui lui-même dépend du nombre de voies de l'IHM, chaque bouton poussoir étant associé à une seule voie. D'autre part, lorsque l'IHM est équipée de LEDs pour visualiser l'état de l'ensemble des voies, il est nécessaire d'avoir une LED par voie. L'encombrement de l'IHM est donc proportionnel au nombre de voies et occupe un espace qui peut être élevé au détriment d'autres fonctionnalités ou d'une recherche de compacité de l'IHM.

En outre le coût d'une IHM dépend, pour une part importante, de la dimension de la carte électronique et du nombre de boutons poussoirs.

La présente invention a pour but de remédier à ces inconvénients en proposant un dispositif d'interface optimisée pour la commande des équipements d'une installation électrique permettant de diminuer le coût de l'IHM et l'encombrement de la partie de commande et/ou de visualisation.

A cet effet, le dispositif d'interface optimisée pour la commande des équipements d'une installation électrique, ledit dispositif comprenant un boîtier présentant une face frontale d'interface et renfermant une carte électronique comprenant au moins un bouton poussoir, au moins deux voies prévues pour être reliées fonctionnellement aux équipements en vue de leur commande et à la carte électronique, un sélecteur manuel mobile entre au moins deux positions principales pour la commande manuelle desdites voies, ladite carte électronique comprenant en outre au moins deux pistes conductrices fonctionnelles principales et au moins une piste conductrice de référence, ledit sélecteur comprenant au moins deux éléments de contact, dont l'un, dit élément de contact fonctionnel, est prévu pour être successivement en contact avec les pistes conductrices fonctionnelles et l'autre, dit élément de contact de référence, est prévu pour venir en contact avec la piste conductrice de référence, chaque position principale du sélecteur correspondant à une fermeture du circuit électrique établi par le contact entre l'élément de contact fonctionnel et l'une des pistes conductrices fonctionnelles principales et par le contact entre l'élément de contact de référence et la piste de contact de référence, se caractérise essentiellement en ce que :
- le ou chaque bouton poussoir est associé à un groupe d'au moins deux voies pour permettre leur activation manuelle et, en cas de pluralité de boutons poussoirs, chaque bouton poussoir est associé à un groupe de voies distinct des autres groupes et comportant le même nombre de voies,
- le nombre de positions principales du sélecteur est égal au nombre de voies du ou de chaque groupe de sorte que toutes les voies du ou de chaque groupe peuvent être sélectionnées, pour permettre leur activation manuelle, par le sélecteur, dont chaque position principale a pour effet de sélectionner l'une des voies du ou de chaque groupe,
- la carte électronique est adaptée pour associer fonctionnellement, pour chaque position du sélecteur, la voie sélectionnée avec le bouton poussoir associé ou, en cas de pluralité de boutons poussoirs, l'ensemble des voies sélectionnées simultanément avec les boutons poussoirs associés.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :

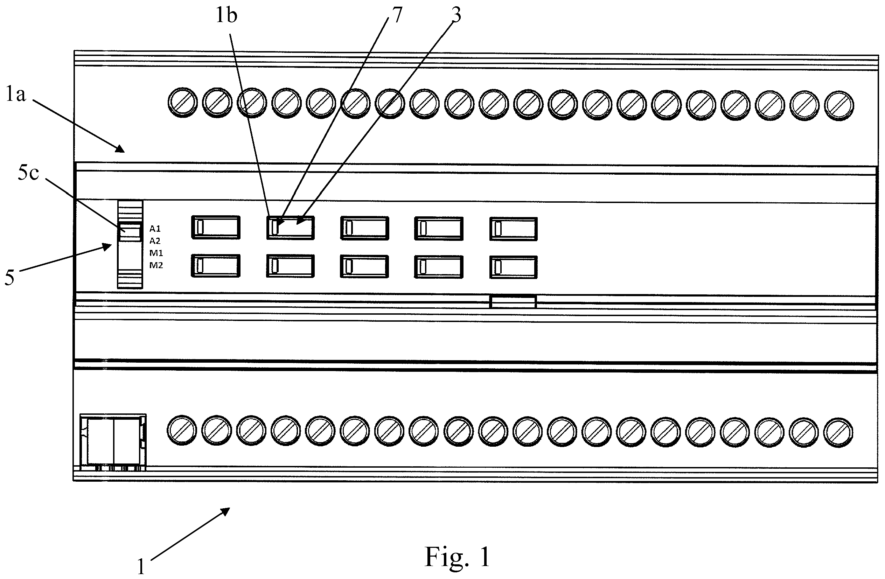

- la figure 1 montre une vue de la face frontale d'interface du dispositif selon la présente invention comportant deux rangées de cinq boutons poussoirs associés chacun à un groupe de deux voies et deux rangées superposées de cinq LEDs situées chacune au niveau de l'un des boutons poussoirs et associés chacune à l'un desdits groupes de sorte à permettre la commande et la visualisation de l'état d'activation de vingt voies à partir de dix boutons poussoirs et de dix LEDs, et un sélecteur à quatre positions permettant de sélectionner, outre les voies à sélectionner dans chaque groupe, un mode manuel et un mode automatique,

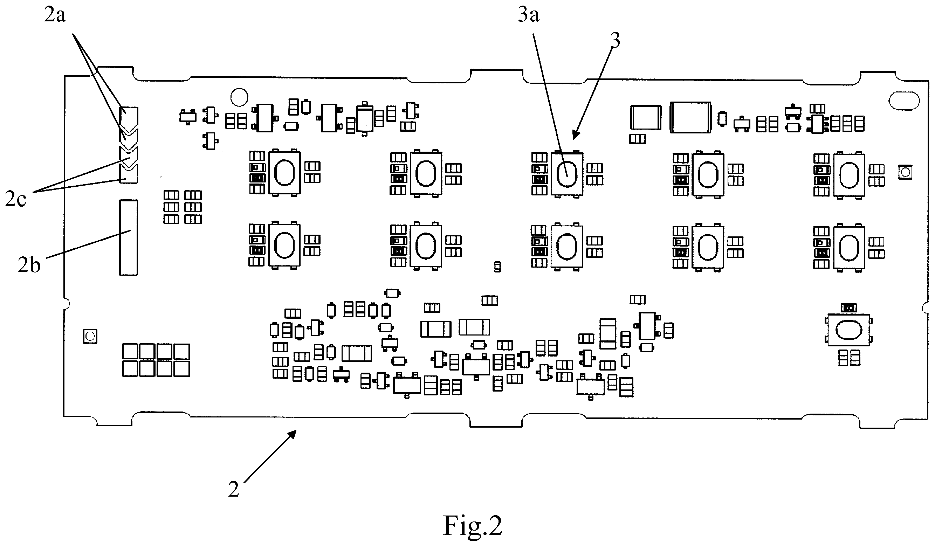

- la figure 2 montre une vue de face de la carte électronique du dispositif représenté sur la figure 1 comprenant deux pistes conductrices principales fonctionnelles permettant la commande manuelle d'un groupe de deux voies par bouton poussoir et deux pistes fonctionnelles additionnelles permettant la commande automatique de chaque voie desdits groupes,

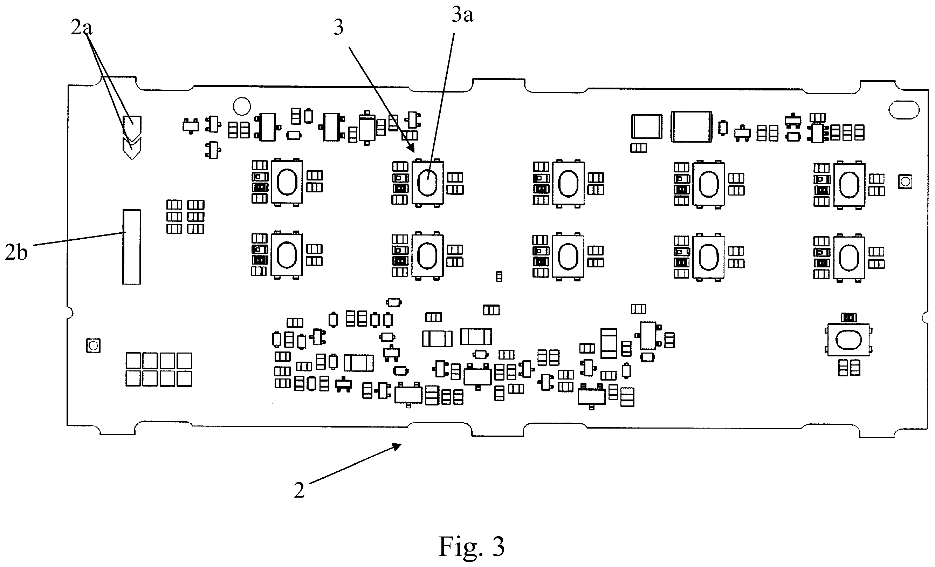

- la figure 3 montre une vue de face d'une carte électronique du dispositif selon l'invention qui comprend le même nombre de boutons poussoirs et de LEDs que la carte de la figure 1 ou de la figure 2 mais avec deux pistes conductrices fonctionnelles principales permettant seulement une commande en mode manuel et non en mode automatique,

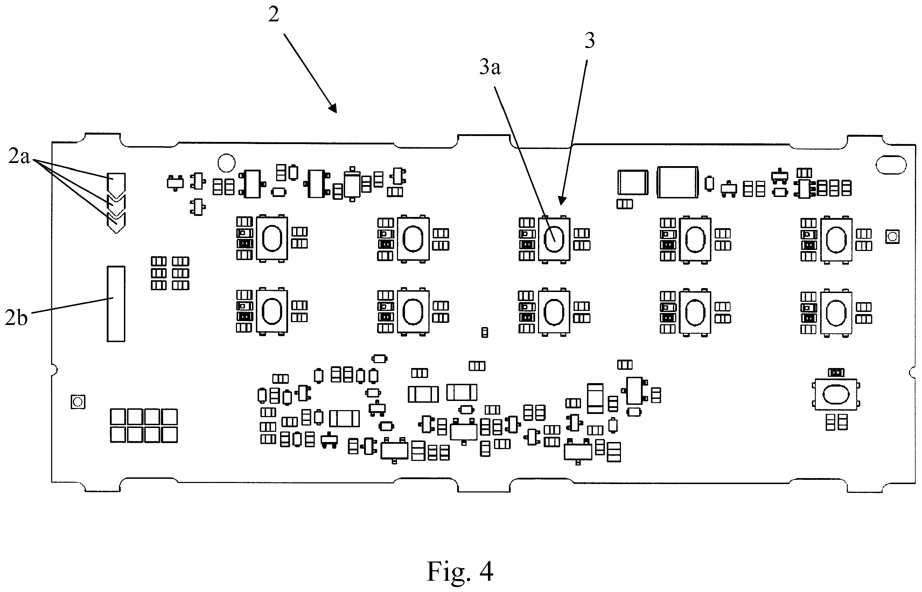

- la figure 4 montre une vue de face d'une carte électronique d'un dispositif selon l'invention comportant deux rangées superposées de cinq boutons poussoirs associés chacun à un groupe de trois voies de trente voies à partir de dix boutons poussoirs et de dix LEDs,

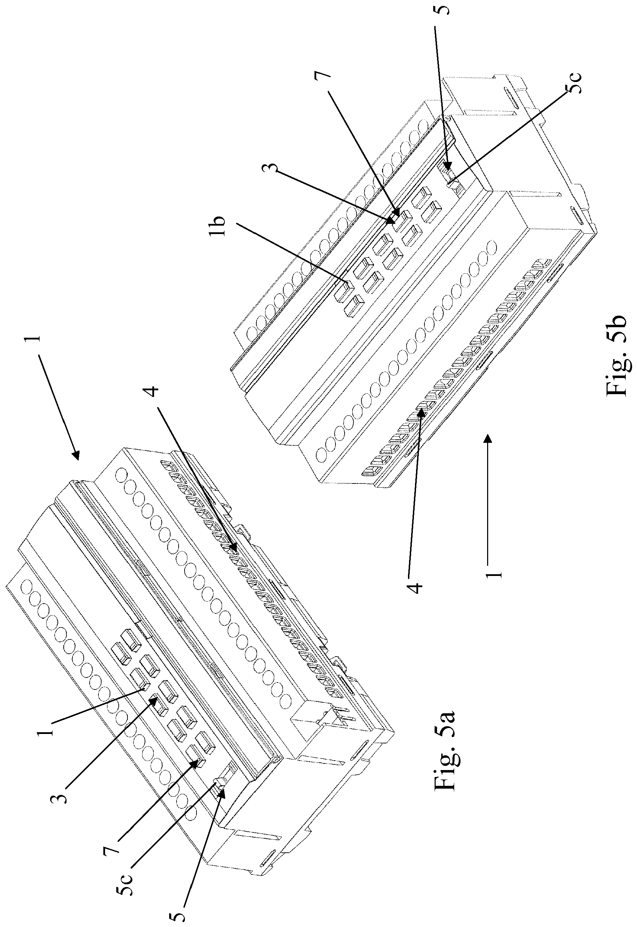

- la figure 5a montre une vue en perspective de trois quart du dispositif représenté sur la figure 1, côté face inférieure,
- la figure 5b montre une vue en perspective de trois quart du dispositif représenté sur la figure 1, côté face supérieure,

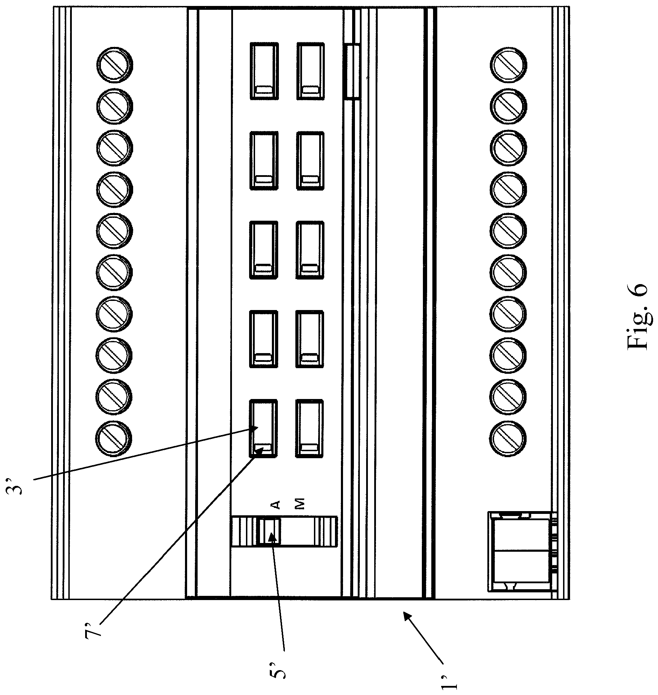

- la figure 6 montre une vue de face d'une carte électronique d'une IHM classique avec deux rangées superposées de cinq boutons poussoirs prévus pour être associés chacun à une seule voie et un sélecteur à deux positions permettant de commander deux modes, à savoir un mode manuel et un mode automatique, et avec deux rangées superposées de cinq LEDs associées chacune à l'un des boutons poussoirs,

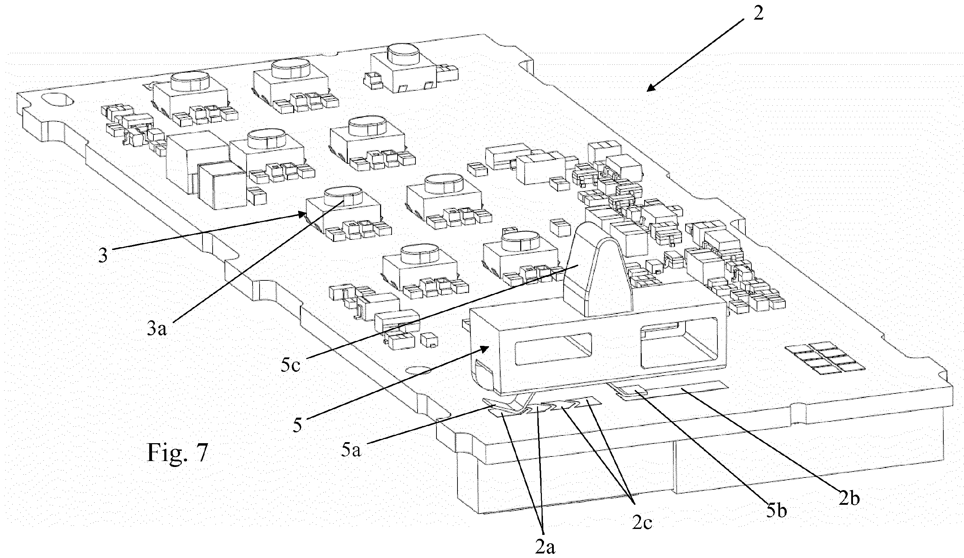

- la figure 7 montre une vue en perspective de la carte électronique représentée sur la figure 2, avec le sélecteur,

Les figures montrent un dispositif d'interface optimisée, selon la présente invention, pour la commande, par exemple en tout ou rien ou de façon graduelle, des équipements d'une installation électrique, ledit dispositif comprenant un boîtier 1 présentant une face frontale la d'interface et renfermant une carte électronique 2 comprenant au moins un bouton poussoir 3, au moins deux voies 4 prévues pour être reliées fonctionnellement aux équipements en vue de leur commande et à la carte électronique 2, un sélecteur 5 manuel mobile entre au moins deux positions principales M1, M2 (figure 1) pour la commande manuelle desdites voies, ladite carte électronique 2 comprenant en outre au moins deux pistes conductrices fonctionnelles 2a principales et au moins une piste conductrice de référence 2b, ledit sélecteur 5 comprenant au moins deux éléments de contact 5a, 5b dont l'un, dit élément de contact fonctionnel 5a, est prévu pour être successivement (à chaque changement de position du sélecteur 5) en contact avec les pistes conductrices fonctionnelles 2a et l'autre, dit élément de contact de référence 5b, est prévu pour venir en contact avec la piste conductrice de référence 2b, chaque position principale du sélecteur 5 correspondant à une fermeture du circuit électrique établi par le contact entre l'élément de contact fonctionnel 5a et l'une des pistes conductrices fonctionnelles 2a principales et par le contact entre l'élément de contact de référence 5b et la piste de contact de référence 2b.

Conformément à la présente invention dans un tel dispositif :
- le ou chaque bouton poussoir 3 est associé à un groupe d'au moins deux voies 4 pour permettre leur activation manuelle, c'est à dire sous l'effet de la sollicitation du ou desdits boutons poussoirs 3, et, le cas échéant, en cas de pluralité de boutons poussoirs 3, chaque bouton poussoir 3 est associé à un groupe de voies 4 distinct des autres groupes et comportant le même nombre de voies 4, et
- le nombre de positions principales du sélecteur 5 est égal au nombre de voies 4 du ou de chaque groupe de sorte que toutes les voies 4 du ou de chaque groupe peuvent être sélectionnées, pour leur activation manuelle, par le sélecteur 5, dont chaque position principale M1, M2 a pour effet de sélectionner l'une des voies 4 du ou de chaque groupe.

Toujours conformément à la présente invention, dans un tel dispositif la carte électronique 2 est adaptée pour associer fonctionnellement, pour chaque position principale M1, M2 du sélecteur 5, la voie 4 sélectionnée avec le bouton poussoir 3 associé ou, en cas de pluralité de bouton poussoir 3, l'ensemble de voies 4 sélectionnées simultanément 4 avec les boutons poussoirs 3 associés. A cet effet, la carte électronique 2 peut comprendre un microcontrôleur relié aux pistes conductrices fonctionnelles et aux voies 4 et un programme de commande mis en oeuvre par ledit microntrôleur.

On comprendra par association fonctionnelle la mise en relation fonctionnelle entre le ou chaque bouton poussoir 3 et la voie 4 sélectionnée par le sélecteur 5 de sorte à permettre l'activation de ladite voie 4 lors d'une sollicitation sur ledit bouton poussoir 3 associé.

Dans un mode de réalisation préférentielle, le dispositif selon la présente invention peut comprendre en outre au moins un témoin lumineux 7 relié à la carte électronique 2, le ou chaque témoin lumineux 7 étant associé au ou à chaque groupe de voies 4 de sorte à pouvoir indiquer visuellement, pour chaque position principale M1, M2 du sélecteur 5, l'état d'activation de la voie 4 sélectionnée du ou de chaque groupe de voies 4 associé audit témoin lumineux. En outre, la carte électronique 2 est adaptée pour associer fonctionnellement la voie 4 sélectionnée du ou de chaque groupe de voies 4 avec le témoin lumineux 7 associé audit groupe (figures 1, 5a, 5b).

D'autre part, par exemple, dans un mode de réalisation particulier du dispositif permettant seulement la commande manuelle, c'est-à-dire sans commande automatique, le dispositif peut comprendre deux pistes conductrices fonctionnelles 2a principales de sorte que le ou chaque bouton poussoir 3 puisse commander un groupe de deux voies 4 et, le cas échéant, le ou chaque témoin lumineux 7, en mode manuel ou automatique, puisse indiquer l'état de l'une ou l'autre des deux voies 4 du groupe associée (figure 3).

Dans un mode de réalisation préférentiel permettant en outre la commande automatique, c'est-à-dire sans prendre en compte les ordres des boutons poussoirs 3 sollicités manuellement, la carte électronique 2 peut être prévue pour être reliée en outre à un réseau de communication filaire ou hertzien, non représenté, associé à chaque voie 4 du ou de chaque groupe de voies 4 pour permettre l'activation automatique desdites voies 4. Le sélecteur 5 peut être mobile en outre, c'est-à-dire en plus de ses positions principales M1, M2, entre au moins deux positions additionnelles A1, A2 pour la commande automatique des voies 4 du ou de chaque groupe de voies 4 et la carte électronique 2 peut comprendre en outre au moins deux pistes conductrices fonctionnelles 2c additionnelles.

D'autre part, dans ce mode de réalisation permettant en outre la commande automatique des voies 4, chaque position additionnelle du sélecteur 5 peut correspondre à une fermeture du circuit (électrique) établi par le contact entre l'élément de contact fonctionnel 5a et l'une des pistes conductrices fonctionnelles 2a additionnelles et par le contact entre l'élément de contact de référence 5b et la piste de contact de référence 2b. En outre, le nombre de positions additionnelles du sélecteur 5 peut être égal au nombre de voies 4 du ou de chaque groupe. En outre, chaque voie 4 de chaque groupe peut être sélectionnée automatiquement quelque soit la position A1, A2 du sélecteur 5 en étant commandé par le réseau.

Par ailleurs, toujours dans ce mode de réalisation particulier permettant en outre la commande automatique des voies 4 et lorsque le dispositif prévoit au moins un témoin lumineux 7, le ou chaque témoin lumineux 7 pouvant être associé au ou à chaque groupe de voies 4 de sorte à indiquer visuellement en outre, pour chaque position additionnelle A1, A2 du sélecteur 5, l'état d'activation de la voie 4 sélectionnée du ou de chaque groupe de voies 4 associé audit témoin lumineux. En outre, la carte électronique 2 peut être adaptée pour associer fonctionnellement, pour chaque position additionnelle A1, A2 du sélecteur 5, chaque voie 4 sélectionnée du groupe avec le témoin lumineux 7 associé audit groupe ou, en cas de pluralité de boutons poussoirs 3, chaque voie 4a sélectionnée dans chaque groupe avec le témoin lumineux 7 associé au groupe correspondant.

On comprendra par association fonctionnelle la mise en relation fonctionnelle entre le ou chaque bouton poussoir 3 et la voie 4 sélectionnée par le sélecteur 5 de sorte à permettre l'activation de ladite voie 4 lors d'une sollicitation sur ledit bouton poussoir 3 associé.

Dans le cas d'un réseau filaire, celui-ci peut comprendre un bus du type bus KNX ou autre protocole ou standard de communication ou de transmission d'information.

Dans un mode de réalisation préférentielle du dispositif permettant une commande manuelle et automatique des voies 4, la carte électronique peut comprendre de préférence deux ou trois pistes conductrices fonctionnelles 2a principales et deux ou trois pistes conductrices fonctionnelles 2c additionnelles de sorte que chaque bouton poussoir 3 peut commander, en mode manuel, un groupe de deux ou trois voies 4 et chaque témoin lumineux 7 peut indiquer, en mode manuel ou automatique, l'état d'activation chaque voies 4 du groupe associé audit témoin lumineux 7 (figures 1, 2, 7).

Dans un mode de réalisation préférentiel du dispositif comportant une pluralité de boutons poussoirs 3 et, le cas échéant, une pluralité de témoins lumineux 7, la présente invention peut prévoir, par exemple :
- deux rangées superposées de quatre boutons poussoirs 3, et quatre groupes de deux ou trois voies 4 associés chacun à l'un des boutons poussoirs 3 et, le cas échéant, une pluralité de témoins lumineux 7, en nombre égal au nombre de groupes auxquels ils sont chacun associés, de sorte à pouvoir commander manuellement ou, le cas échéant, automatiquement et le, cas échéant, à visualiser l'état d'activation, de seize ou vingt-quatre voies 4, ou
- deux rangées superposées de cinq boutons poussoirs 3, et cinq groupes de deux ou trois voies 4 associées chacun à l'un des boutons poussoirs 3 et, le cas échéant, une pluralité de témoins lumineux 7, en nombre égal au nombre de groupes auxquels ils sont chacun associés de sorte à pouvoir commander manuellement ou, le cas échéant, automatiquement et le, cas échéant, à visualiser l'état d'activation, de vingt ou trente voies 4 (figures 1, 2, 3, 4, 5a, 5b, 6, 7).

De préférence, le sélecteur 5 peut comprendre un organe de préhension 5c permettant le déplacement manuel du sélecteur et le ou chaque bouton poussoir 3 peut comprendre un corps 3a monté fonctionnellement sur la carte électronique 2 et une tête 3b permettant l'activation manuelle du ou de chaque bouton poussoir. En outre, la face frontale la du boîtier 1 peut comporter au moins une rangée d'au moins une ouverture 1b capable de laisser passer la tête du ou de l'un des boutons poussoirs 3 et la lumière émise par le ou l'un des témoins lumineux associés.

On comprendra que le dispositif selon l'invention permet ainsi de réduire notablement les dimensions de la carte électronique 2 qui comporte moins de boutons poussoirs 3 que dans un IHM classique (figure 6) pour le même nombre de voies à commander et, le cas échéant, moins de témoins lumineux 7, auxquelles réductions il faut ajouter la réduction du nombre de composants, tels que les résistances, ou les connections associés à chaque bouton poussoir 3 ou témoin lumineux 7 (LED) ce qui a pour effet de faire baisser le coût de production d'une IHM notablement, c'set à dire d'environ 40 % d'après des calculs effectués par la présente demanderesse. En outre, la présente l'invention permet d'éviter les stocks de cartes différentes, c'set à dire comportant un nombre de boutons poussoirs différent en fonction du nombre de voies à commander puisque par exemple une carte de n boutons poussoirs peut être prévu pour commander un nombre de voies égale à plus de deux fois le nombre de boutons. Ainsi la même carte électronique peut être utilisée dans deux dispositifs différents, sans que ce soit perçu à l'extérieur du produit.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

## Revendications

1. Dispositif d'interface optimisée pour la commande des équipements d'une installation électrique, ledit dispositif comprenant un boîtier (1) présentant une face frontale (1a) d'interface et renfermant une carte électronique (2) comprenant au moins un bouton poussoir (3), au moins deux voies (4) prévues pour être reliées fonctionnellement aux équipements en vue de leur commande et à la carte électronique (2), , ladite carte électronique (2) comprenant en outre au moins deux pistes conductrices fonctionnelles (2a) principales et au moins une piste conductrice de référence (2b), le ou chaque bouton poussoir (3) étant associé à un groupe d'au moins deux voies (4) pour permettre leur activation manuelle et, en cas de pluralité de boutons poussoirs (3), chaque bouton poussoir (3) est associé à un groupe de voies (4) distinct des autres groupes et comportant le même nombre de voies (4),
dispositif **caractérisé en ce qu'**il comprend en outre un sélecteur (5) manuel mobile entre au moins deux positions principales (M1, M2) pour la commande manuelle desdites voies, ledit sélecteur (5) comprenant au moins deux éléments de contact (5a, 5b) dont l'un, dit élément de contact fonctionnel (5a), est prévu pour être successivement en contact avec les pistes conductrices fonctionnelles (2a) et l'autre, dit élément de contact de référence (5b), est prévu pour venir en contact avec la piste conductrice de référence (2b), chaque position principale du sélecteur (5) correspondant à une fermeture du circuit électrique établi par le contact entre l'élément de contact fonctionnel (5a) et l'une des pistes conductrices fonctionnelles (2a) principales et par le contact entre l'élément de contact de référence (5b) et la piste de contact de référence (2b),
le nombre de positions principales du sélecteur (5) étant égal au nombre de voies (4) du ou de chaque groupe de sorte que toutes les voies (4) du ou de chaque groupe peuvent être sélectionnées, pour leur activation manuelle par le ou les boutons poussoirs (3), par le sélecteur (5), dont chaque position principale (M1, M2) a pour effet de sélectionner l'une des voies (4) du ou de chaque groupe,
la carte électronique (2) étant adaptée pour associer fonctionnellement, pour chaque position principale (M1, M2) du sélecteur (5), la voie (4) sélectionnée avec le bouton poussoir (3) associé ou, en cas de pluralité de boutons poussoirs (3), l'ensemble des voies (4) sélectionnées simultanément (4) avec les boutons poussoirs (3) associés.

2. Dispositif, selon la revendication 1, **caractérisé en ce qu'**il comprend en outre au moins un témoin lumineux (7) relié à la carte électronique (2), le ou chaque témoin lumineux (7) étant associé au ou à chaque groupe de voies (4) de sorte à pouvoir indiquer visuellement, pour chaque position principale (M1, M2) du sélecteur (5), l'état d'activation de la voie (4) sélectionnée du ou de chaque groupe de voies (4) associé audit témoin lumineux et **en ce que** la carte électronique (2) est adaptée pour associer fonctionnellement la voie (4) sélectionnée du ou de chaque groupe de voies (4) avec le témoin lumineux (7) associé audit groupe.

3. Dispositif, selon la revendication 1 ou la revendication 2, **caractérisé en ce que**
- la carte électronique (2) est prévue pour être reliée en outre à un réseau de communication filaire ou hertzien associé à chaque voie (4) du ou de chaque groupe de voies (4) pour permettre l'activation automatique desdites voies,
- le sélecteur (5) est mobile en outre entre au moins deux positions additionnelles (A1, A2) pour la commande automatique desdites voies et la carte électronique (2) comprend en outre au moins deux pistes conductrices fonctionnelles (2c) additionnelles, chaque position additionnelle du sélecteur (5) correspondant à une fermeture du circuit électrique établi par le contact entre l'élément de contact fonctionnel (5a) et l'une des pistes conductrices fonctionnelles (2a) additionnelles et par le contact entre l'élément de contact de référence (5b) et la piste de contact de référence (2b),
- chaque voie (4) de chaque groupe est sélectionnée automatiquement quelque soit la position (A1, A2) du sélecteur en étant commandé par le réseau,
- le nombre de positions additionnelles du sélecteur (5) est égal au nombre de voies (4) du ou de chaque groupe,
- le ou chaque témoin lumineux (7) étant associé au ou à chaque groupe de voies (4) de sorte à indiquer visuellement en outre, pour chaque position additionnelle (A1, A2) du sélecteur (5), l'état d'activation de la voie (4) sélectionnée du ou de chaque groupe de voies (4) associé audit témoin lumineux,
- la carte électronique (2) est adaptée pour associer fonctionnellement, pour chaque position additionnelle (A1, A2) du sélecteur (5), chaque voie (4) sélectionnée du groupe avec le témoin lumineux (7) associé audit groupe ou, en cas de pluralité de boutons poussoirs (3), chaque voie (4a) sélectionnée dans chaque groupe avec le témoin lumineux (7) associé au groupe correspondant.

4. Dispositif, selon la revendications 3, **caractérisé en ce que** la carte électronique comprend en outre deux pistes conductrices fonctionnelles (2a) principales et deux pistes ou trois conductrices fonctionnelles (2c) de sorte que chaque bouton poussoir (3) puisse commander, en mode manuel, un groupe de deux ou trois voies (4) et que chaque témoin lumineux, en mode manuel ou automatique, puisse indiquer l'état d'activation de chaque voie (4) du groupe associé.

5. Dispositif, selon l'une quelconque des revendications 1 à 4, **caractérisé en ce que** le sélecteur (5) comprend un organe de préhension (5c) permettant le déplacement manuel du sélecteur et le ou chaque bouton poussoir (3) comprend un corps (3a) monté fonctionnellement sur la carte électronique et une tête (3b) permettant l'activation manuelle du ou de chaque bouton poussoir et **en ce que** la face frontale (1a) comporte au moins une rangée d'au moins une ouverture (1b) capable de laisser passer la tête du ou de l'un des boutons poussoirs (3) et la lumière émise par le ou l'un des témoins lumineux associés.

## Patentansprüche

1. Schnittstellenvorrichtung, optimiert zur Betätigung von Geräten einer elektrischen Installation, wobei die genannte Vorrichtung ein Gehäuse (1) umfasst, das eine Schnittstellenfrontfläche (1a) aufweist und eine elektronische Platine (2) umschließt, die mindestens einen Druckknopf (3) aufweist, mindestens zwei Pfade (4), die dafür bestimmt sind, funktionell mit den Geräten zu deren Betätigung und mit der elektronischen Platine (2) verbunden zu werden, wobei die genannte elektronische Platine (2) außerdem mindestens zwei funktionelle Hauptleiterbahnen (2a) und mindestens eine Bezugsleiterbahn (2b) aufweist, wobei der oder jeder Druckknopf (3) einer Gruppe von mindestens zwei Pfaden (4) zugeordnet ist, um deren manuelle Betätigung zu ermöglichen, und im Falle mehrerer Druckknöpfe (3) jeder Druckknopf (3) mit einer Pfadgruppe (4) verbunden ist, die von den anderen Gruppen verschieden ist und dieselbe Anzahl an Pfaden (4) aufweist,
Vorrichtung, **dadurch gekennzeichnet, dass** sie außerdem einen zwischen mindestens zwei Hauptstellungen (M1, M2) manuell beweglichen Wahlschalter (5) zur manuellen Betätigung der genannten Pfade umfasst, wobei der genannte Wahlschalter (5) mindestens zwei Kontaktteile (5a, 5b) umfasst, deren eines, funktionelles Kontaktteil (5a) genannt, dafür vorgesehen ist, sukzessiv mit den funktionellen Leiterbahnen (2a) in Kontakt zu stehen, und das andere, Bezugskontaktteil (5b) genannt, dafür vorgesehen ist, mit der Bezugsleiterbahn (2b) in Kontakt zu kommen, wobei jede Hauptstellung des Wahlschalters (5) einem Schließen des Stromkreises entspricht, der durch den Kontakt des funktionellen Kontaktteils (5a) mit einer der funktionellen Leiterbahnen (2a) und durch den Kontakt des Bezugskontaktteils (5b) mit der Bezugsleiterbahn (2b) gebildet wird,
wobei die Anzahl der Hauptstellungen des Wahlschalters (5) der Anzahl an Pfaden (4) der oder jeder Gruppe gleich ist, derart, dass alle Pfade (4) der oder jeder Gruppe zu ihrer manuellen Betätigung durch den oder die Druckknöpfe (3) durch den Wahlschalter (5) ausgewählt werden können, dessen jede Hauptstellung (M1, M2) zur Folge hat, einen der Pfade (4) der oder jeder Gruppe auszuwählen,
wobei die elektronische Platine (2) dafür ausgebildet ist, für jede Hauptstellung (M1, M2) des Wahlschalters (5) den mit dem zugeordneten Druckknopf (3) ausgewählten Pfad (4) oder im Falle mehrerer Druckknöpfe (3), die Gesamtheit der mit den zugeordneten Druckknöpfen gleichzeitig ausgewählten Pfade (4), funktionell zu verbinden.

2. Vorrichtung nach Patentanspruch 1, **dadurch gekennzeichnet, dass** sie außerdem mindestens eine mit der elektronischen Platine (2) verbundene Kontrollleuchte (7) umfasst, wobei die oder jede Kontrollleuchte (7) der oder jeder Pfadgruppe (4) zugeordnet ist, so dass sie für jede Hauptstellung (M1, M2) des Wahlschalters (5) den Betätigungszustand des ausgewählten Pfades (4) der oder jeder der genannten Anzeigelampe zugeordneten Pfadgruppe (4) visuell anzeigen kann und dadurch, dass die elektronische Platine (2) dafür ausgebildet ist, den ausgewählten Pfad (4) der oder jeder Pfadgruppe (4) mit der der genannten Gruppe zugeordneten Kontrollleuchte (7) funktionell zu verbinden.

3. Vorrichtung nach Patentanspruch 1 oder Patentanspruch 2, **dadurch gekennzeichnet, dass**
- die elektronische Platine (2) dafür vorgesehen ist, außerdem an ein Kabel- oder Funkfernmeldenetz, das jedem Pfad (4) der oder jeder Pfadgruppe (4) zugeordnet ist, angeschlossen zu sein, um die automatische Betätigung der genannten Pfade zu erlauben,
- der Wahlschalter (5) außerdem zwischen mindestens zwei zusätzlichen Stellungen (A1, A2) für die automatische Betätigung der genannten Pfade beweglich ist und die elektronische Platine (2) außerdem mindestens zwei zusätzliche Leiterbahnen (2c) umfasst, wobei jede zusätzliche Stellung des Wahlschalters (5) einem Schließen des Stromkreises entspricht, der durch den Kontakt zwischen dem funktionellen Kontaktteil (5a) und einer der zusätzlichen funktionellen Leiterbahnen (2a) und durch den Kontakt zwischen dem Bezugskontaktteil (5b) und der Bezugskontaktbahn (2b) gebildet wird,
- jeder Pfad (4) jeder Gruppe unabhängig von der Stellung (A1, A2) des Wahlschalters automatisch ausgewählt wird, indem er über das Netz betätigt wird,
- die Anzahl zusätzlicher Stellungen des Wahlschalters (5) gleich der Anzahl an Pfaden (4) der oder jeder Gruppe ist.
- die oder jede Anzeigelampe (7) der oder jeder Pfadgruppe (4) zugeordnet ist, derart dass sie außerdem für jede zusätzliche Stellung (A1, A2) des Wahlschalters (5) den Betätigungszustand des ausgewählten Pfades (4) der oder jeder der genannten Anzeigelampe zugeordneten Pfadgruppe (4) visuell anzeigt,
- die elektronische Platine (2) dafür ausgebildet ist, für jede zusätzliche Stellung (A1, A2) des Wahlschalters (5) jeden ausgewählten Pfad (4) der Gruppe mit der der genannten Gruppe zugeordneten Anzeigelampe (7) oder im Falle mehrerer Druckknöpfe (3), jeden ausgewählten Pfad (4a) jeder Gruppe mit der der entsprechenden Gruppe zugeordneten Anzeigelampe (7) funktionell zu verbinden.

4. Vorrichtung nach Patentanspruch 3, **dadurch gekennzeichnet, dass** die elektronische Platine außerdem zwei funktionelle Hauptleiterbahnen (2a) und zwei oder drei funktionelle Leiterbahnen (2c) umfasst, derart dass jeder Druckknopf (3) bei manueller Betätigung eine Gruppe von zwei oder drei Pfaden (4) betätigen kann, und dass jede Anzeigelampe bei manuellem oder automatischem Betrieb den Betätigungszustand jedes Pfades (4) der zugeordneten Gruppe anzeigen kann.

5. Vorrichtung nach irgendeinem der Patentansprüche 1 bis 4, **dadurch gekennzeichnet, dass** der Wahlschalter (5) ein Greiforgan (5c) umfasst, das das manuelle Bewegen des Wahlschalters erlaubt, und der oder jeder Druckknopf (3) einen Körper (3a) umfasst, der auf der gedruckten Schaltung funktionell montiert ist, sowie einen Kopf (3b), der die manuelle Betätigung des oder jedes Druckknopfes erlaubt, und dadurch, dass die Frontplatte (1a) mindestens eine Reihe mit mindestens einer Öffnung (1b) aufweist, geeignet, den Kopf des oder eines der Druckknöpfe (3) durchzulassen, sowie das Licht, das von der oder einer der zugeordneten Anzeigelampen abgegeben wird.

## Claims

1. Optimised interface device for controlling systems of an electrical installation, said device comprising a housing (1) having an interface front face (1a) and containing an electronic board (2) comprising at least one pushbutton switch (3), at least two tracks (4) provided to be connected functionally to equipment for the control of the latter and to the electronic board (2), said electronic board (2) also comprising at least two main functional conductor tracks (2a) and at least one reference conductor track (2b), the or each pushbutton switch (3) being associated with a group of at least two tracks (4) to enable their manual activation and in the case of a plurality of pushbutton switches (3), each pushbutton switch (3) is associated with a group of tracks (4) different from the other groups and comprising the same number of tracks (4),
the device being **characterised in that** it also comprises a manual switch (5) which is movable between at least two main positions (M1, M2) for the manual control of said tracks, said switch (5) comprising at least two contact elements (5a, 5b) one of which, said functional contact element (5a), being provided to be successively in contact with the functional conductor tracks (2a) and the other, said reference contact element (5b), being provided to come into contact with the reference conductor track (2b), each main position of the switch (5) corresponding to the closure of the electric circuit established by the contact between the functional contact element (5a) and one of the main functional conductor tracks (2a) and by the contact between the reference contact element (5b) and the reference contact track (2b),
the number of main positions of the switch (5) being equal to the number of tracks (4) of the or of each group such that all of the tracks (4) of the or of each group can be selected for their manual activation by the pushbutton switch or switches (3), by the switch (5), of which each main position (M1, M2) has the effect of selecting one of the tracks (4) of the or of each group,
the electronic board (2) being adapted to associate functionally for each main position (M1, M2) of the switch (5), the selected track (4) with the associated pushbutton switch (3) or, in case of a plurality of pushbutton switches (3), the entirety of tracks (4) selected simultaneously with the associated pushbutton switches (3).

2. Device according to claim 1, **characterised in that** it also comprises at least one indicator light (7) connected to the electronic board (2), the or each indicator light (7) being associated with the or with each group of tracks (4) so as to indicate visually for each main position (M1, M2) of the switch (5) the activation state of the selected track (4) of the or of each group of tracks (4) associated with said indicator light and **in that** the electronic board (2) is adapted to connect functionally the selected track (4) of the or of each group of tracks (4) with the indicator light (7) associated with said group.

3. Device according to claim 1 or claim 2, **characterised in that**
- the electronic board (2) is provided to be connected additionally to a wired or wireless communications network associated with each track (4) of the or of each group of tracks (4) to enable the automatic activation of said tracks,
- the switch (5) is also mobile between at least two additional positions (A1, A2) for the automatic control of said tracks and the electronic board (2) also comprises at least two additional functional conductor tracks (2c), each additional position of the switch (5) corresponding to a closure of the electric circuit established by the contact between the functional contact element (5a) and any of the additional functional conductor tracks (2a) and by contact between the reference contact element (5b) and the reference contact track (2b),
- each track (4) of each group is selected automatically regardless of the position (A1, A2) of the switch by being controlled by the network,
- the number of additional positions of the switch (5) is equal to the number of tracks (4) of the or of each group,
- the or each indicator light (7) being associated with the or with each group of tracks (4) so as to indicate additionally, for each additional position (A1, A2) of the switch (5), the selected activation state of the track (4) of the or of each group of tracks (4) associated with said light indicator,
- the electronic board (2) is adapted to associate functionally for each additional position (A1, A2) of the switch (5), each track (4) selected from the group with the indicator light (7) associated with said group or, in the case of a plurality of pushbutton switches (3), each track (4a) selected in each group with the indicator light (7) associated with the corresponding group.

4. Device according to claim 3, **characterised in that** the electronic board also comprises two main functional conductor tracks (2a) and two tracks or three functional conductors (2c) such that each pushbutton switch (3) can control in manual mode a group of two or three tracks (4) and that each light indicator, in manual or automatic mode, can indicate the activation state of each track (4) of the associated group.

5. Device according to any of claims 1 to 4, **characterised in that** the switch (5) comprises a gripping member (5c) permitting the manual displacement of the switch and the or each pushbutton switch (3) comprises a body (3a) mounted functionally on the electronic board and a head (3b) permitting the manual activation of the or each pushbutton switch and **in that** the front face (1a) comprises at least a line of at least one opening (1b) capable of allowing the passage of the head of the or of one of the pushbutton switches (3) and the light emitted by the or one of the associated light indicators.
